Europäisches Patentamt

European Patent Office

Office européen des brevets

(19)

(11) Publication number: **0 210 783 B1**

# EUROPEAN PATENT SPECIFICATION

(45) Date of publication of patent specification: **13.11.91**   (51) Int. Cl.⁵: **H03H 7/25**

(21) Application number: **86305422.7**

(22) Date of filing: **15.07.86**

(54) Pin diode switched RF step attenuator.

(30) Priority: **23.07.85 US 758608**

(43) Date of publication of application:
**04.02.87 Bulletin 87/06**

(45) Publication of the grant of the patent:
**13.11.91 Bulletin 91/46**

(84) Designated Contracting States:
**DE FR GB**

(56) References cited:
**US-A- 3 518 585**
**US-A- 4 050 055**

**PATENT ABSTRACTS OF JAPAN, vol. 8, no. 285 (E-287)[1722], 26th December 1984; & JP-A-59 152 710 (HITACHI SEISAKUSHO K.K.) 31 Août 1984**

(73) Proprietor: **Hewlett-Packard Company**
**P.O. Box 10301 3000 Hanover Street**
**Palo Alto California 94303-0890(US)**

(72) Inventor: **Dasilva, Marcus K.**
**S. 2807 Fox Road**
**Spokane, WA 99206(US)**

(74) Representative: **Colgan, Stephen James et al**
**CARPMAELS & RANSFORD 43 Bloomsbury Square**
**London WC1A 2RA(GB)**

## Description

Field of Invention

The present invention relates generally to a variable step RF attenuator and more particularly to an RF attenuator with a plurality of attenuating sections which can be cascaded with each other utilizing PIN diode switches.

Background of the Invention

Switchable step attenuators which are intended to provide attenuation at selectively adjustable levels are well-known in the art. Typically, the prior art attenuator devices employ a series of attenuator sections designed to provide attenuation in discrete steps. The attenuator sections are switched into and out of the circuit by switches, either mechanical or electronic. The well-known "decade box" provides an example of a prior art variable attenuator device.

In RF applications, the attenuator requires broad bandwidth, e.g., from DC to gigahertz range, and accuracy, ± 0.1 dB, and the attenuator must be matched to a transmission line characteristic impedance. Typically, RF attenuators employ several T-attenuator or PI-attenuator sections with switching elements to either select or bypass each attenuator section. Double pole, double throw mechanical switches, relays, for example, are suitable for low-speed operation. High-speed applications may require rapid switching of attenuator sections for long periods of time. Because of the nature and construction of relays and other types of mechanical switches, such switches tend to wear out when utilized in high speed applications.

Electronic switches, such as a PIN diode, can be used to provide high speed switching of broadband RF signals. PIN diodes have low capacitance when in the OFF state and a low resistance in the ON state and can be switched by a current signal. U.S. Patent number 4,359,699 issued to Philip R. Horkin on November 16, 1982 provides an example of PIN diodes used in the prior art to construct a linear attenuator.

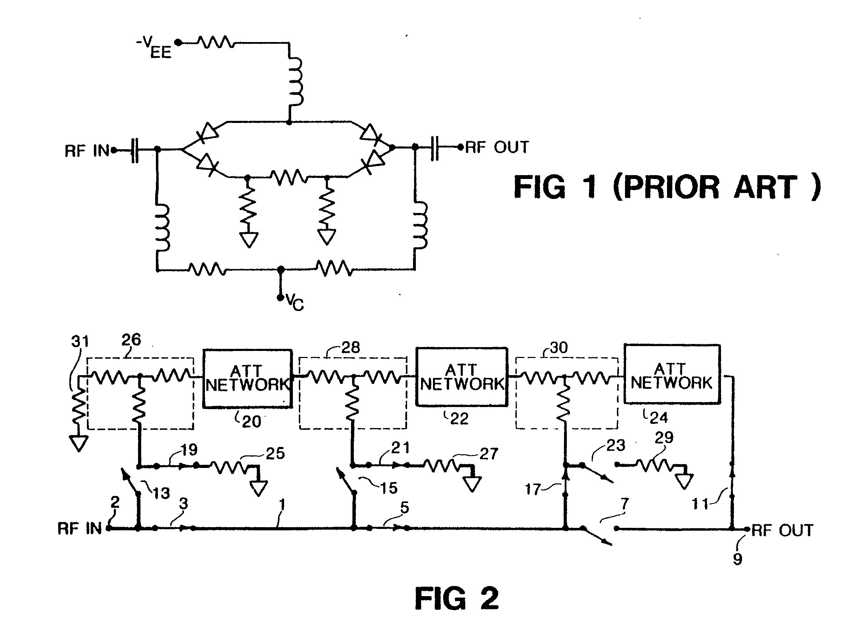

Stepped attenuators comprised of several PI or T-pad attenuating elements switched into or out of a circuit utilizing PIN diodes are also known. An example of a prior art switched PI attenuator element is shown in Figure 1. In the attenuator configuration shown Figure 1, four PIN diodes and three RF chokes are required. Each attenuator element, when in the bypassed condition, has the insertion loss of two PIN diodes. As a result, PIN diode switched attenuators typically have higher insertion losses than mechanically switched stepped attenuators. The isolation provided by each PIN diode is limited which increases the number of PIN diodes required to provide good RF isolation which further increases the insertion loss. Additionally, as shown in Figure 1, two control lines are required for each attenuator element.

Japanese Patent Abstract 59-152710 discloses a switching type variable attenuation circuit which provides a first signal path having minimum signal attenuation when a series of switches are closed, and a selection of second signal paths. The attenuation of the second signal path is varied according to which of the switches are in the open state. When a switch is opened, a corresponding attenuation shunt stage changes the signal attenuation.

Summary of the Invention

According to the invention, there is provided a dual-path ladder-type variable RF signal attenuator comprising: an electrical conductor having an input terminal, an output terminal and a plurality of first electronic switching means connected in series fashion between the input terminal and the output terminal to provide a first signal path having minimum signal attenuation; a plurality of attenuator stages connected in cascade fashion, each stage having an input and an output, the input of each stage selectively connectable to the conductor, the output of the last stage selectively connected by an output switch to the output terminal of the conductor, to provide a plurality of selectable second signal paths, each of said second signal paths having a different predetermined signal attenuation, each of said plurality of first electronic switch means associated with one of said plurality of attenuator stages, each of first electronic switch means shunting said associated attenuation stage when in the on state and opening said electrical conductor when in the off state; characterised in that: said variable RF signal attenuator further comprises a plurality of second electronic switch means, each of said second switch means interconnected between the electrical conductor and the input of one of said plurality of attenuator stages for selectively connecting said attenuator stages to the electrical conductor; each of said plurality of attenuator stages further includes power splitters; and the variable RF signal attenuator further includes a plurality of first control lines and a second control line, each of said first control lines coupled to a different one of said plurality of second electronic switch means and the second control line coupled to said output terminal to provide a biasing signal to said plurality of first and second electronic switch means and to said output switch to select a desired one of said signal paths whereby, for each attenuator stage, its associated first switch means is on when its associated second switch means and the output switch are off, and vice versa.

Preferably, PIN diodes are utilized to switch attenuation elements into or out of a ladder-type step attenuator. The circuit is configured such that, regardless of how many attenuator elements are switched into the circuit, one end of the power splitter element is always terminated in the input RF transmission line characteristic impedance.

The use of PIN diodes provides a step attenuator which is all electronic with no mechanical switches or moving parts providing improved reliability and which takes advantage of the high-speed switching and long life characteristics of PIN diodes. The configuration requires fewer RF chokes than the prior art attenuator element shown in Figure 1 thereby reducing costs and improving high frequency response. The design requires only one drive line per attenuator element. By minimizing the number of through line PIN diodes required, insertion loss is reduced without any reduction in isolation.

Brief Description of the Drawings

Figure 1 illustrates a diode-switched attenuator element as used in the prior art.

Figure 2 is a block diagram of a ladder-type variable stepped attenuator according to the principles of the present invention.

Figure 3 is a schematic diagram of the variable stepped attenautor illustrated in Figure 2.

Description of the Preferred Embodiment

Referring now to Figure 2, a variable stepped attenuator utilizing the switching characteristics of PIN diodes is provided. The network is comprised of a through put line 1 having an RF input 2 and RF output 9. A ladder-type step attenuator is formed by arranging power splitter blocks 26, 28 and 30 and attenuator network elements 20, 22 and 24 as shown. Each attenuator network 20, 22 and 24 will attenuate the signal by a predetermined amount, 10 dB for example. If switches 3, 5 and 7 are closed and switches 13, 15, 17 and 11 are open, then an RF signal input at RF input 2 is passed through on line 1 unattenuated (in the ideal case). If switches 3, 5, 17, 11, 19 and 21 are closed and switches 13, 15, 23 and 7 are open, the RF signal input at RF input 2 will be attenuated by the product of the power splitter 30 attenuation and the attenuation of the attenuation network 24. Similarly, if switches 3, 15, 11, 19 and 23 are closed and switches 5, 7, 13, 21 and 17 are open, the RF signal attenuation will be the product of the attenuation of power splitters 28 and 30 and attenuation networks 22 and 24. If each power splitter 26, 28 , 30 is 6 dB and each attenuator network 20, 22, 24 is 4 dB, the entire network will provide 0-30 dB attenuation in 10 dB steps. Adding more steps to the ladder extends the attenuation range.

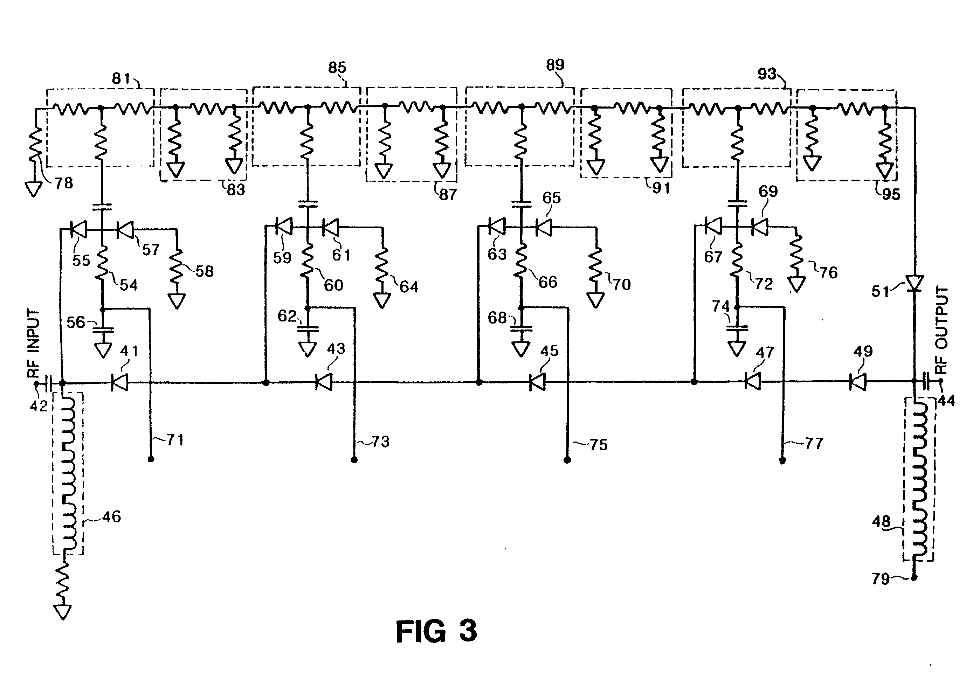

Referring now to Figure 3, a schematic diagram of a 0-60 dB step attenuator providing attenuation of 0, 10, 30, 50, and 60 dB is shown. The step ladder attenuator is comprised of throughput line 40, power splitter blocks 81, 85, 89 and 93 and attenuator networks 83, 87, 91 and 95. Attenuation networks 83, 87, 91 and 95 comprise three resistors each arranged as a PI attenuator element. PIN diodes operated as single-pole single-throw switches that are "on" when current flows through the diodes (forward biased) and "off" when reverse biased. In each case, only one bias or control line 71, 73, 75, 77 or 79 is required for each attenuator setting.

The number of RF chokes required by the attenuator is minimized by utilizing asymetric power splitters 81, 85, 89 and 93 and resistors 54, 60, 66 and 72 to provide resistive biasing for the diodes. Resistors 58, 64, 70, 76 and 78 are the characteristic impedance of the transmission lines, 50 ohms for example. The values of the attenuation networks 83, 87, 91 and 95 are adjusted to compensate for the power splitter asymetry. The power splitters are matched so that all RF inputs and outputs are matched to the characteristic impedance, 50 ohms for example, at any setting of the attenuator. Capacitors 56, 62, 68 and 74 provide an ac ground to prevent RF feedthrough and minimizes crosstalk between the control lines 71, 73, 75 and 77. RF chokes 46 and 48 provide a high impedance to any RF signal thereby isolating the throughput line 40 from RF ground and the dc bias supply. RF chokes 46 and 48 are selected to minimize self-reasonance effects over the bandwidth of the attenuator.

If line 79 is held high and control lines 71, 73, 75 and 77 are held low, PIN diodes 41, 43, 45, 47, 49, 57, 61, 65 and 69 are on and PIN diodes 55, 59, 63, 67 and 51 are off allowing the RF input signal at input 42 to pass through the attenuator on line 40 with no attenuation (other than the insertion losses of diodes 41, 43, 45, 47 and 49). If control line 77 is held high and the remaining lines 71, 73, 75 and 79 are held low, diodes 41, 43, 45, 67, 51, 57, 61 and 65 are on and diodes 47, 49, 55, 59, 63 and 69 are off. The attenuation of the RF input signal at the RF output 44 will be the product of the power splitter 93 attenuation and the attenuation network 95 attenuation. The remainder of the RF input signal will be terminated in the input line characteristic impedance. PIN diode 49 provides additional isolation when power splitter 93 and attenuator network 95 are the only attenuation elements in the ladder. Similarly, by holding a desired control line high and the remaining control lines low, any one of the available attenuation settings may be achieved.

## Claims

1. A dual-path ladder-type variable RF signal attenuator comprising:

an electrical conductor having an input terminal (42), an output terminal (44) and a plurality of first electronic switching means (41, 43, 45, 47, 49) connected in series fashion between the input terminal and the output terminal to provide a first signal path (40) having minimum signal attenuation;

a plurality of attenuator stages (83, 87, 91, 95) connected in cascade fashion, each stage having an input and an output, the input of each stage selectively connectable to the conductor, the output of the last stage selectively connected by an output switch (51) to the output terminal of the conductor, to provide a plurality of selectable second signal paths, each of said second signal paths having a different predetermined signal attenuation, each of said plurality of first electronic switch means associated with one of said plurality of attenuator stages, each of first electronic switch means shunting said associated attenuation stage when in the on state and opening said electrical conductor when in the off state; characterised in that:

said variable RF signal attenuator further comprises a plurality of second electronic switch means (55, 59, 63, 67), each of said second switch means interconnected between the electrical conductor and the input of one of said plurality of attenuator stages for selectively connecting said attenuator stages to the electrical conductor;

each of said plurality of attenuator stages further includes power splitters (81, 85, 89, 93); and

the variable RF signal attenuator further includes a plurality of first control lines (71, 73, 75, 77) and a second control line (79), each of said first control lines coupled to a different one of said plurality of second electronic switch means and the second control line coupled to said output terminal (44) to provide a biasing signal to said plurality of first and second electronic switch means and to said output switch to select a desired one of said signal paths whereby, for each attenuator stage, its associated first switch means is on when its associated second switch means and the output switch are off, and vice versa.

2. A variable RF signal attenuator as in claim 1 wherein said first and second electronic switch means and the output switch comprise diodes.

3. A variable RF signal attenuator as in claim 2 wherein said diodes comprise PIN diodes.

4. A variable RF signal attenuator as in any one of claims 1 to 3, wherein each of said plurality of attenuation stages comprise a resistive attenuator network.

5. A variable RF signal attenuator as in any one of claims 1 to 4, in which each of said power splitters comprises a T-pad resistor network, each resistor network being coupled between the output of one attenuator stage and the input of the next attenuator stage and the electrical conductor.

6. A variable RF signal attenuator as in any one of claims 1 to 5, in which said attenuation network further comprises a plurality of third electronic switch means (57, 61, 65, 69), each of said third switch means being coupled to a different attenuator stage input, said third electronic switch means being responsive to said biasing signal when the associated second electronic switch means is off.

7. A variable RF signal attenuator as in claim 6, wherein said third electronic switch means comprises diodes.

8. A variable RF signal attenuator as in claim 7, wherein said diodes comprise PIN diodes.

## Revendications

1. Atténuateur de signal radio-fréquence variable du type en chaîne à double voie comprenant :

un conducteur électrique ayant une borne d'entrée (42), une borne de sortie (44) et une pluralité de premiers moyens de commutation électronique (41, 43, 45, 47, 49) connectés en série entre la borne d'entrée et la borne de sortie pour constituer une première voie de signal (40) ayant une atténuation de signal minimale ;

une pluralité d'étages d'atténuateurs (83, 87, 91, 95) connectés en cascade, chaque étage ayant une entrée et une sortie, l'entrée de chaque étage pouvant être connectée de manière sélective au conducteur, la sortie du dernier étage étant connectée de manière sélective au moyen d'un commutateur de sortie (51) à la borne de sortie du conducteur pour constituer une pluralité de secondes voies de signal sélectionnables, chacune desdites secondes voies de signal ayant une atténuation de signal prédéterminée différente, chacun de ladite pluralité de premiers moyens de commutation électronique étant associé à l'un de ladite pluralité d'étages d'atténuateurs, chacun des premiers moyens de commutation électronique dérivant ledit étage d'atténuation associé lorsqu'il est dans l'état passant et ouvrant ledit conducteur électrique lorsqu'il est dans l'état bloqué ;

caractérisé en ce que :

ledit atténuateur de signal radio-fréquence variable comprend en outre une pluralité de seconds moyens de commutation électronique (55, 59, 63, 67), chacun desdits seconds moyens de commutation étant interconnecté entre le conducteur électrique et l'entrée d'un de ladite pluralité d'étages d'atténuateurs pour connecter de manière sélective lesdits étages d'atténuateurs au conducteur électrique ;

chacun de ladite pluralité d'étages d'atténuateurs inclut en outre des diviseurs de puissance (81, 85, 89, 93) ; et

l'atténuateur de signal radio-fréquence variable inclut en outre une pluralité de premières lignes de commande (71, 73, 75, 77) et une seconde ligne de commande (79), chacune desdites premières lignes de commande étant couplée à un différent moyen de commutation différent de ladite pluralité de seconds moyens de commutation électronique et la seconde ligne de commande étant couplée à ladite borne de sortie (44) pour fournir un signal de polarisation à ladite pluralité de premiers et de seconds moyens de commutation électronique et audit commutateur de sortie afin de sélectionner une voie souhaitée desdites voies de signal, et ainsi, pour chaque étage d'atténuateur, son premier moyen de commutation associé est passant lorsque son second moyen de commutation associé et le commutateur de sortie sont bloqués et vice-versa.

2. Atténuateur de signal radio-fréquence variable selon la revendication 1, dans lequel lesdits premiers et seconds moyens de commutation électronique et le commutateur de sortie comprennent des diodes.

3. Atténuateur de signal radio-fréquence variable selon la revendication 2, dans lequel lesdites diodes comprennent des diodes PIN.

4. Atténuateur de signal radio-fréquence variable selon l'une quelconque des revendications 1 à 3, dans lequel chacun de ladite pluralité d'étages d'atténuation comprend un réseau d'atténuateurs résistifs.

5. Atténuateur de signal radio-fréquence variable selon l'une quelconque des revendications 1 à 4, dans lequel chacun desdits diviseurs de puissance comprend un réseau de résistances d'atténuateurs en T, chaque réseau de résistances étant couplé entre la sortie d'un étage d'atténuateur et l'entrée de l'étage d'atténuateur suivant et le conducteur électrique.

6. Atténuateur de signal radio-fréquence variable selon l'une quelconque des revendications 1 à 5, dans lequel ledit réseau d'atténuation comprend en outre une pluralité de troisièmes moyens de commutation électronique (57, 61, 65, 69), chacun desdits troisièmes moyens de commutation étant couplé à une entrée d'étage d'atténuateur différente, lesdits troisièmes moyens de commutation électronique étant sensibles audit signal de polarisation lorsque le second moyen de commutation électronique associé est bloqué.

7. Atténuateur de signal radio-fréquence variable selon la revendication 6, dans lequel lesdits troisièmes moyens de commutation électronique comprennent des diodes.

8. Atténuateur de signal radio-fréquence variable selon la revendication 7, dans lequel lesdites diodes comprennent des diodes PIN.

## Patentansprüche

1. Variables Dämpfungsglied für Hochfrequenzsignale vom Zwei-Wege-Stufentyp, das umfaßt:

einen elektrischen Leiter mit einem Eingangsanschluß (42), einem Ausgangsanschluß (44) und mehreren ersten elektronische Schalteinrichtungen (41, 43, 45, 47, 49), die in Serie zwischen den Eingangsanschluß und den Ausgangsanschluß geschaltet sind, um einen ersten Signalweg (40) mit minimaler Signaldämpfung zu bilden;

mehrere Dämpfungsstufen (83, 87, 91, 95), die kaskadenartig geschaltet sind, wobei jede Stufe einen Eingangsanschluß und einen Ausgangsanschluß hat, wobei der Eingangsanschluß einer jeden Stufe selektiv mit dem Leiter verbindbar ist, wobei der Ausgangsanschluß der letzten Stufe selektiv mittels eines Ausgangsschalters (51) mit dem Ausgangsanschluß des Leiters verbunden ist, um mehrere wählbare zweite Signalwege zu bilden, wobei jeder der zweiten Signalwege eine andere vorbestimmte Signaldämpfung aufweist, wobei jede der ersten elektronischen Schalteinrichtungen einer der mehreren Dämpfungsstufen zugeordnet ist, wobei jede der ersten elektronischen Schalteinrichtungen in eingeschaltetem Zustand die zugehörige Dämpfungsstufe überbrückt und in ausgeschaltetem Zustand den elektrischen Leiter öffnet;

dadurch **gekennzeichnet,** daß

das variable Dämpfungsglied für Hochfrequenzsignale ferner mehrere zweite elektronische Schalteinrichtungen (55, 59, 63, 67) umfaßt, wobei jede der zweiten Schalteinrichtungen zwischen den elektrischen Leiter und den Eingangsanschluß einer der mehreren Dämpfungsstufen geschaltet ist, und zwar zum selektiven Verbinden der Dämpfungsstufen mit dem elektrischen Leiter;

jede der mehreren Dämpfungsstufen ferner Leistungsteiler (81, 85, 89, 93) umfaßt und

das variable Dämpfungsglied für Hochfrequenzsignale ferner mehrere erste Steuerleitungen (71, 73, 75, 77) sowie eine zweite Steuerleitung (79) umfaßt, wobei jede der ersten Steuerleitungen mit einer anderen der mehreren zweiten elektronischen Schalteinrichtungen verbunden ist und die zweite Steuerleitung mit dem Ausgangsanschluß (44) verbunden ist, um ein vorspannendes Signal an die mehreren ersten und zweiten elektronischen Schalteinrichtungen und den Ausgangsschalter zu geben, um einen gewünschten der Signalwege auszuwählen, wodurch für jede Dämpfungsstufe gilt, daß die ihm zugeordnete erste Schalteinrichtung eingeschaltet ist, wenn die ihm zugeordnete zweite Schalteinrichtung und der Ausgangsschalter ausgeschaltet sind, und umgekehrt.

2. Variables Dämpfungsglied für Hochfrequenzsignale nach Anspruch 1, wobei die erste und die zweite elektronische Schalteinrichtung und der Ausgangsschalter Dioden umfassen.

3. Variables Dämpfungsglied für Hochfrequenzsignale nach Anspruch 2, wobei die Dioden PIN-Dioden umfassen.

4. Variables Dämpfungsglied für Hochfrequenzsignale nach einem der Ansprüche 1 bis 3, wobei jede der mehreren Dämpfungsstufen ein Widerstand-Dämpfungsnetzwerk umfaßt.

5. Variables Dämpfungsglied für Hochfrequenzsignale nach einem der Ansprüche 1 bis 4, bei dem jeder der Leistungsteiler ein T-Glieder-Widerstandsnetzwerk umfaßt, wobei jedes Widerstandsnetzwerk zwischen den Ausgangsanschluß einer Dämpfungsstufe und den Eingangsanschluß der nächsten Dämpfungsstufe und den elektronischen Leiter geschaltet ist.

6. Variables Dämpfungsglied für Hochfrequenzsignale nach einem der Ansprüche 1 bis 5, wobei das Dämpfungsnetzwerk ferner mehrere dritte elektronische Schalteinrichtungen (57, 61, 65, 69) umfaßt, wobei jede der dritten Schalteinrichtungen mit einem anderen Dämpfungsstufeneingangsanschluß verbunden ist, wobei die dritten elektronischen Schalteinrichtungen auf das Vorspannsignal reagieren, wenn die zugeordnete zweite elektronische Schalteinrichtung ausgeschaltet ist.

7. Variables Dämpfungsglied für Hochfrequenzsignale nach Anspruch 6, wobei die dritten elektronischen Schalteinrichtungen Dioden umfassen.

8. Variables Dämpfungsglied für Hochfrequenzsignale nach Anspruch 7, wobei die Dioden PIN-Dioden umfassen.

FIG 1 (PRIOR ART )

FIG 2

EP 0 210 783 B1

EP 0 210 783 B1

**FIG 3**